# EUROPÄISCHE PATENTSCHRIFT

(11) **EP 2 914 563 B1**
(45) Veröffentlichungstag und Bekanntmachung des Hinweises auf die Patenterteilung: **30.06.2021**
(21) Anmeldenummer: 13788923.4
(22) Anmeldetag: 30.10.2013
(51) Int. Cl.: C04B 35/622, C04B 35/626, C04B 35/632, C04B 35/636, C04B 35/638, C04B 35/117, C04B 35/119, A61C 13/00, B28B 1/00, B29C 67/00, H05K 3/12

(54) **DRUCKVERFAHREN**
PRINTING PROCESS
PROCÉDÉ D'IMPRESSION

(30) Priorität: 31.10.2012 DE 102012219989
(43) Veröffentlichungstag der Anmeldung: 09.09.2015
(73) Patentinhaber: WZR Ceramic Solutions GmbH, 53359 Rheinbach (DE)
(72) Erfinder: KOLLENBERG, Wolfgang, 50321 Brühl (DE)
(74) Vertreter: Claessen, Rolf
(86) Internationale Anmeldenummer: PCT/EP2013/072696
(87) Internationale Veröffentlichungsnummer: WO 2014/067990

(56) Entgegenhaltungen:
- EP-A1- 2 233 449
- DE-A1-102004 008 122
- DE-A1-102008 022 664
- VILARDELL M ET AL: "Ink Jet Printing for Functional Ceramic Coatings", JOURNAL OF IMAGING SCIENCE AND TECHNOLOGY, SPIE - THE INTERNATIONAL SOCIETY FOR OPTICAL ENGINEERING, US, Bd. 55, Nr. 4, 1. Juli 2011 (2011-07-01), Seiten 40304-1, XP008166337, ISSN: 1062-3701, DOI: 10.2352/J.IMAGINGSCI.TECHNOL.2011.55.4.040 304
- MELCHER R ET AL: "Kap. 3.4.2.3 Herstellung keramisch-metallischer Formkoerper durch 3D-Drucken", TECHNISCHE KERAMISCHE WERKSTOFFE, DKG / DEUTSCHER WIRTSCHAFTSDIENST, HVB-VERLAG, DE , Nr. 96. Ergänzungslieferung 1. Januar 2007 (2007-01-01), Seiten 1-16, XP008166328, Gefunden im Internet: URL:www.hvb-verlag.com in der Anmeldung erwähnt
- None

## Beschreibung

Die vorliegende Erfindung betrifft ein Verfahren zur Herstellung eines keramischen Grünkörpers.

Der bei der Entwicklung keramischer Komponenten notwendige Entwicklungsaufwand kann durch die schnelle Bereitstellung von Prototypen erheblich reduziert werden. Designänderungen können unmittelbar, auf beispielsweise CAD-Daten basierend, in Komponenten umgesetzt werden, ohne Werkzeuge ändern zu müssen.

Der Begriff Rapid Prototyping bezeichnet die schnelle Herstellung von Prototypen und bezieht sich auf eine Technologie, die seit Anfang der 1990er Jahre durch stetige Weiterentwicklung mit leistungsfähiger, computergestützter Steuerungs- und Regeltechnik für generative Fertigungsverfahren geeignet ist. Der Bezeichnung Rapid Prototyping wer-den Begriffe wie "Rapid Tooling" und "Rapid Manufacturing" untergeordnet. Dabei handelt es sich Weiterentwicklung des eigentlichen Prozesses, die spezielle Anwendungs- und Einsatzgebiete beschreiben. Der Begriff Rapid Prototyping bezeichnet im Allgemeinen die Technologie, Rapid Tooling hingegen den generativen Werkzeugbau als Anwendungsgebiet, während der Begriff Rapid Manufacturing für die generative Serienfertigung steht.

In der Metall- und vor allem in der Kunststoffindustrie gehört das Verfahren des Rapid Prototyping zum Stand der Technik. Dadurch ist es in der Regel möglich, Komponenten direkt auf Basis von 3D CAD-Daten herzustellen. Innerhalb weniger Stunden lassen sich kostengünstig hochkomplexe und filigrane Strukturen realisieren. Somit können Entwicklungszeiten und - kosten deutlich reduziert werden und ebenso wird die Zeit bis zur Markteinführung neuer Komponenten erheblich verkürzt.

Keramische Werkstoffe haben derzeit immer noch das grundsätzliche Problem, dass ihr Potential bei Ingenieuren und Konstrukteuren nicht hinreichend bekannt ist. Daher ist für diese Werkstoffgruppe der Einsatz von sehr schnellen, computergestützten Verfahren zur Fertigung von Prototypen von besonderer Bedeutung.

Der bislang relativ lange und kostenintensive Herstellungsprozess, bestehend aus Modellentwicklung, Formenbau, Optimierung der Arbeitsform, Aufbereitung der Rohstoffe, Formgebung, Sinterprozess und Nachbearbeitung, führt in der Regel zu langen Entwicklungszyklen. Für Hersteller und Anwender ist ein Verfahren zur schnellen und kosten-günstigen Bereitstellung von Prototypen erforderlich.

Zur Realisierung der zeitsparenden, kostengünstigen Prototypenherstellung können verschiedene Methoden herangezogen werden. Neben der bekannten Grünbearbeitung liegen Forschungsarbeiten speziell zu den Themen Lasersintern, Heißgießen und 3D-Druck vor.

Es wurden auch bereits Methoden bereitgestellt, die es ermöglichen in kurzer Zeit (5-10 Tage) Prototypen aus keramischen Werkstoffen zu generieren. Die Prototypen sollen die entsprechenden Eigenschaften des späteren Serienproduktes aufweisen.

DE 103 06 887 A7 beschreibt ein Verfahren zur Herstellung eines keramischen Grünkörpers, wobei Partikel von keramischem Pulver mit einer Beschichtung versehen werden können, die davon unterschiedliche Nanopartikel enthält.

DE 10 2006 029 298 A1 beschreibt ein Materialsystem für das 3D-Drucken, wobei das beschriebene Verfahren auch zu einem keramischen Formkörper führen kann.

DE 20 2005 020 596 U1 beschreibt ein Pulver für das Rapid Prototyping, wobei ein keramischer Formkörper durch Lasersintern entsteht.

DE 10 2005 058 118 A1 beschreibt ein Verfahren zum Herstellen keramischer Bauteile, wobei die keramischen Bauteile durch Lasersintern entstehen.

DE 10 2005 058 116 A1 beschreibt ein Verfahren zum Herstellen von keramischen Implantaten, wobei diese mit einem Laser lokal ausgehärtet werden.

DE 10 2006 015 014 A1 beschreibt ein Verfahren und eine Vorrichtung dreidimensionaler keramischer Formkörper, wobei eine Suspension von keramischen Partikeln mit einem Tintenstrahldrucker verdruckt wird.

DE 10 2005 058 121 A1 beschreibt ein Verfahren zum Herstellen keramischer Bauteile, wobei der Grünling lokal mit einem Laser ausgehärtet werden kann.

DE 602 07 204 T2 beschreibt dreidimensional strukturiertes Drucken zur Herstellung von Polymerkörpern. In diesen Polymerkörpern können auch Nanopartikel eingebracht sein.

DE 10 2004 008 122 A1 beschreibt beschichtete Pulverpartikel für die Herstellung von dreidimensionalen Körpern mittels schichtaufbauenden Verfahren, wobei die Pulverpartikel beschichtet sein können.

EP 0 431 924 A2 beschreibt ein Verfahren, bei dem Bindemittel auf Keramikpulver aufgebracht werden.

DE 10 2008 022 664 A1 beschreibt ein Druckverfahren für keramische Komponenten.

Der Artikel "Herstellung keramisch-metallischer Formkörper durch 3D-Drucken" (Melcher et al., Keramische Werkstoffe, Januar 2007, 3.4.2.4.) beschreibt gedruckte Aluminiumoxid-Dextrin-Grünkörper und daraus entstandene keramische Formkörper.

VILARDELL M ET AL, "Ink Jet Printing for Functional Ceramic Coatings", JOURNAL OF IMAGING SCIENCE AND TECHNOLOGY, SPIE - THE INTERNATIONAL SOCIETY FOR OPTICAL ENGINEERING, US, (20110701), vol. 55, no. 4, ISSN 1062-3701, pages 40304 - 1, XP008166337, beschreibt ein Druckverfahren für funktionelle Keramikbeschichtungen.

EP 2 233 449 A1 beschreibt einen Schlicker für die Herstellung von Dentalkeramiken mittels Hot-Melt-Inkjet-Druckverfahren.

Die bislang bekannten Verfahren haben verschiedene Nachteile. So wird in einigen Verfahren das keramische Material, welches den späteren keramischen Formkörper ausmacht, in einer Suspension verdruckt. Dies erfordert eine hohe Feststoffkonzentration in der zu druckenden Suspension, wodurch die Druckdüsen verstopft werden. Mit den vorgenannten Verfahren können die Eigenschaften des entstehenden keramischen Formkörpers nicht über die räumliche Ausdehnung des keramischen Formkörpers hinweg variiert werden. Zwar ist es bereits bekannt, zusätzliche Partikel zu dem keramischen Pulver hinzuzufügen. Dies geschieht jedoch bislang beispielsweise durch Beschichten der keramischen Artikel und anschließendes Verdrucken für die Herstellung des Grünkörpers. Dadurch können dem keramischen Formkörper zwar Eigenschaften verliehen werden, die von dem ursprünglich eingesetzten keramischen Pulver nicht erzeugt werden können. Diese Eigenschaften können jedoch nicht so erzeugt werden, dass diese an unterschiedlichen Stellen des Formkörpers unterschiedlich ausgeprägt sind. Zudem ist bislang ein aufwändiges Beschichtungsverfahren der keramischen Partikel dazu notwendig.

Aufgabe der vorliegenden Erfindung ist es daher, ein einfaches Verfahren bereitzustellen, mit dem einem keramischen Formkörper unabhängig von dem ursprünglich eingesetzten keramischen Material eine bestimme Eigenschaft verliehen werden kann.

Diese der Erfindung zugrunde liegende Aufgabe wird gelöst in einer ersten Ausführungsform durch ein Verfahren zur Herstellung eines Grünkörpers, bei dem man
a) eine Schicht, die ein keramisches, glaskeramisches oder Glaspulver enthält, auf einer Unterlage bildet,
   wobei die Schicht durch Aufbringen des Pulvers auf die Unterlage bzw. die zuvor gebildete Schicht und anschließendes Nivellieren des aufgebrachten Pulvers gebildet wird,
b) mindestens eine flüssige Verfestigungszusammensetzung auf die zuvor genannte Schicht auf zumindest einen Teil davon appliziert, die wenigstens 0,01 bis 99,98 Gew.% wenigstens einer gelösten oder flüssigen organometallischen Verbindung enthält, wobei diese wenigstens ein Atom aufweist, das nicht C, Si, H, O oder N ist, und dieses Atom an wenigstens einen organischen Rest gebunden ist,
   0,01 bis 20 Gew.% eines organischen Binders,
   0,01 bis 99,98 Gew.% Lösungsmittel oder Dispergiermittel enthält, wobei die Verfestigungszusammensetzung mit einem Druckkopf eines Tintenstrahldruckers, einem Mikrodispenser, einem Mikrodosierer, einem Piezodruckkopf oder einem frei programmierbaren Dosiersystem aufgebracht wird, und
   wobei die Verfestigungszusammensetzung keine Feststoffe enthält,
c) Schritte a) und b) mindestens einmal wiederholt,
d) das Lösungsmittel oder Dispergiermittel unter Bildung eines Grünkörpers wenigstens teilweise oder vollständig entfernt, und
e) nicht gebundenes keramisches Pulver entfernt, wobei der Grünkörper freigelegt wird.

Bei dem erfindungsgemäßen Verfahren handelt es sich um ein generatives Verfahren, bei dem Material nicht bearbeitet wird, sondern neue Formkörper oder Grünkörper entstehen.

Dispergiermittel im Sinne der Erfindung ist die flüssige Phase der Dispersion, beispielsweise im Fall, dass die Verfestigungszusammensetzung ein Kolloid ist.

Der Vorteil des erfindungsgemäßen Verfahrens vor allem gegenüber der DE 10 2008 022 664 A1 ist, dass die Druckköpfe der eingesetzten Drucker nicht mehr durch die zuvor eingesetzten Nanopartikel verstopfen und ein wesentlich homogeneres Farbbild des Produktes erreicht werden kann.

Schließt man eine thermische Behandlung an, wird die Organoelementverbindung beispielsweise zu anorganischen metallischen oder nichtmetallischen Verbindungen umgewandelt. Auf diese Weise gelingt es ortsaufgelöst Eigenschaften wie Farbe, Festigkeit, Härte, elektrische Leitfähigkeit, Wärmeleitfähigkeit, thermische Dehnung, magnetische Eigenschaften, piezoelektrische Eigenschaften, induktive Eigenschaften, kapazitative Eigenschaften oder optische Eigenschaften zu beeinflussen.

Weitere Vorteile sind, dass auf diesem Wege aus ästhetischen oder technischen Gründen gewünschte Eigenschaftsverläufe, -sprünge oder Gradierungen in beliebiger Weise realisiert werden können.

Die Schicht in a) kann vorzugsweise auch Bindemittel enthalten.

Die Verfestigungszusammensetzung kann auch 0,1 bis 99,9 Gew.% Dispergiermittel als Lösungsmittel enthalten. Das Dispergiermittel kann also auch aus den vorgeschlagenen Lösungsmitteln ausgewählt sein.

Nach Schritt c) d) kann es bevorzugt sein, etwaiges Dispergiermittel oder Lösungsmittel unter Bildung eines Grünkörpers wenigstens teilweise oder vollständig zu entfernen.

Die Verfestigungszusammensetzung kann auch 0,1 bis 99 Gew.% einer kolloidalen Dispersion mit einem durchschnittlichen Durchmesser der dispergierten Phasen in einem Bereich weniger als 5 nm, und im Übrigen Dispergiermittel enthalten. Das Dispergiermittel kann identisch mit dem Lösungsmittel sein.

Das Dispergiermittel oder Lösungsmittel ist vorzugsweise ausgewählt aus der Gruppe Alkohole, Glykole, Ether, Glykolether, Acetate, Ethanol, Dimethylformamid, Toluol, Methanol, Chlorbenzol, Diethylformamid, Dimethylsulfoxid, Wasser, Wasserstoffperoxid, Methylamin, Natronlauge, N-Methylpolidonether, Acetonitril, Methylcyanid, Ethannitril, Azetonitril, Essigsäurenitril, Ethansäurenitril, Cyanomethan, Benzylchlorid, Triethylamin, Ethylenglykol, Tetrahydrofuran (THF), Tetramethylenoxid, 1,4-Epoxybutan, Oxacyclopentan, Oxolan, Acetophenon, Anisol, Benzylalkohol, Butylacetat, Cyclohexanol, 1,4-Dioxan, Dimethylacetamid, n-Dodecan, Ethylbenzen, Diethyleneglycol, Hexylbenzen, Hexyliodid, Methyl-Benzoate, N-Methyl-Pyrrolidone, 1-Octanol, 1,3-Propanediol, Propylen Carbonat, p-Xylen, Diethylenglykolmonobutylether, Diethylenglykolmonobutyletheracetat, Ethylenglykolmonobutylether, Diiodmethan, Ethylenglykolmonophenylether, Terpineol, und/oder Tetradekan oder Kombinationen derselben.

Dispergiermittel im Sinne der Erfindung ist die flüssige Phase der Dispersion.

Die Organoelementverbindung ist eine organometallische Verbindung sein. Unabhängig davon weist die organometallische Verbindung wenigstens ein Metallatom auf, das aus folgenden Elementen ausgewählt ist: Al, B, Be, Bi, Ca, Ce, Cr, Cu, K, Fe, Ga, Ge, In, Li, Mg, Mn, Mo, Na, Sn, Sr, Ta, Ti, V, Co, Ni, Zn, Rb, Sr, Nb, Ru, Rh, Pd, Ag, Cd, In, Sb, Cs, Ba, La, Hf, Ta, Re, Os, Ir, Au, Tl, Pb, Po, W, Y, Pt, und/oder Zr. Bevorzugt weist die organometallische Verbindung Fe, Pt, Zr oder Y auf. Vorzugsweise kann es sich um eine komplexe organometallische Verbindung handeln. Die Komplexbildner können ausgewählt sein aus der Gruppe Carbonyl, Alkyl, Alkyliden, Alkylidin oder Kombinationen derselben.

Bei der organometallischen Verbindung kann es sich vorzugsweise um ein organisches Salz handeln, dessen Anion von organischen Säuren abgeleitet ist. Dies können vorzugsweise die Salze der Cabonsäuren, wie beispielsweise Acetate, Palmitate und Citrate, die Salze der organischen Sulfate, wie beispielsweise Laurylsulfate, die Salze der Oxalsäure (Oxalate), Salze der Weinsäure (Tartrate), Salze der Milchsäure (Lactate), Salze der Gluconsäure (Gluconate), Salze der Fumarsäure (Fumarate) oder die Salze von Alkoholen (Alkoholate) , wie beispielsweise Ethanolate, sein.

Ferner können Amine, die organische Abkömmlinge (Derivate) des Ammoniaks (NH₃), eingesetzt werden.

In der Verfestigungszusammensetzung liegen vorzugsweise Verbindungen, in denen ein organischer Rest oder eine organische Verbindung direkt an ein Metallatom gebunden ist, in Lösung vor. Die Verfestigungszusammensetzung ist flüssig. Die Verfestigungszusammensetzung enthält keine Feststoffe. Die Verfestigungszusammensetzung ist vorzugsweise eine Lösung aus einem Lösungsmittel und darin gelösten Bestandteilen. Dadurch kann sichergestellt werden, dass der Druckkopf nicht verstopft.

Vorzugsweise wird die organometallische Verbindung so gewählt, dass nach einer thermischen Behandlung oberhalb 400°C, vorzugsweise oberhalb 1000°C die organischen Bestandteile in die Gasphase überführt werden und die Metallionen - in Abhängigkeit der jeweiligen Atmosphäre - zu Metalloxiden, -carbide, -nitriden oder -carbonitriden reagieren.

Die organometallische Verbindung weist vorzugsweise 1 bis 3 Metallatome und 1 bis 3 Liganden oder organische Reste auf. Die Liganden oder organischen Reste weisen wiederum vorzugsweise jeweils unabhängig voneinander 1 bis 10 Kohlenstoffatome auf. Besonders bevorzugt weist die organometallische Verbindung nur ein Metallatom auf. Die organometallische Verbindung ist vorzugsweise bei 20 °C und 1 bar flüssig oder löslich. Die organometallische Verbindung ist vorzugsweise in Wasser löslich, ohne sich dabei innerhalb von 2 h zu zersetzen.

Die organometallische Verbindung im Sinne der Erfindung kann auch eine oder mehrere organometallischen Verbindungen umfassen. Sie kann also vorzugsweise auch eine Mischung mehrerer organometallischer Verbindungen sein. Insbesondere ist die organometallische Verbindung daher ausgewählt aus einer oder mehrerer der folgenden Verbindungen (nach Metallen geordnet). Jegliche für den Fachmann plausiblen Kombinationen der folgenden Substanzen und Komponenten sind hiermit offenbart:
Lithium (Li): Butyllithium, Milchsäure-Lithiumsalz, Lithiumacetat, Lithiumacetat Dihydrat (Essigsäure Lithiumsalz), Lithium-acetoacetat (Acetessigsäure Lithiumsalz), Lithium-acetylacetonat (Li(acac)), Lithiumacetylid-Ethylendiamin-Komplex, Lithiumaluminiumhydrid-Tetrahydrofuran-Komplex-Lösung (in Toluol), Lithiumaluminium-trri-tetr.-butyloxyhydrid, Lithiumaluminiumtris-[(3-ethyl-3pentyl)-oxy)-hydrid-Lösung (in THF), Lithium-9-borabicyclo[3.3.1]nonan-hydrid-Lösung (in TFT), Lithium-tetr.-butylat-Lösung, Lithiumcarbonat, Lithiumcitrat Hydrat (Citronensäure Trilithiumsalz Hydrat), Lithium-dibutyl-(isopropyl)-magnesat, Lithiumdicyclohexylamid, Lithiumdiethylamid, Lithium-diisobutyl-tetr.-butoxyaluminiumhydrid-Lösung (in tetrahydrofuran, Hexan) Lithium-diisopropylamid-Lösung (in THF/Heptan/Ethylbenzol) , Lithium-diisopropylamid mono-THF-Kompex-Lösung (in Cyclohexan), , Lithium-(dimethylamino)-trihydroborat-Lösung (in THF), Lithium-diphenylphosphid-Lösung (in THF), Lithiumethylat (in Ethanoh, THF), Lithiumformiat Monohydrat (Lithiumsalz der Ameisensäure), Lithiummethylat, Lithium-2-methyl-2-butoxid-Lösung (in Heptane), Lithiummorpholinoborhydrid-Lösung (THF), Lithium-palmitat, Lithium-phenoxid-Lösung (in THF), Lithium-phenylacetylid-Lösung (in THF), Lithiumpyrrolidinoborhydrid-Lösung (in THF), Lithiumsalicilat, Lithiumtetramethylcyclopentadienylid, Lithiumtetraphenylborat-tris-(1,2-dimethoxyethan), Lithium-2-thienylcyanocuprat-Lösung (in THF), Lithiumhiophenolat-Lösung (Thiophenol Lithiumsalz in THF), Lithium-p-toluolsulfinat, Lithium-tetr.-butoxyaluminiumdeuterid, Lithiumtrifluoracetat, Lithiumtrifluormethansulfonat, Lithium-triisobutyl-(2,2,6,6 tetramethylpiperdino)-aluminat-Lösung (in THF), Lithiumtrimethylsilanolat (in Methylenchlorid), Lithium-(trimethylsilyl)-acetylid-Lösung (in THF)
Natrium (Na): Natriumacetate, Natriumacetat Trihydrat, Natriumacetat-Lösung; Natrium-4-amino-salicylat Dihydrat, Natrium-L-ascorbat, Natriumbenzoat, Natrium-benzolsulfinat , Natrium-benzolsulfonat, Natriumbenzyloxid-Lösung (in Benzylalkohol), Natriumbicarbonat, Natriumbiphenyl-Komplex, Natrium-bis-(2-ethylhexyl-d17)sulfosuccionat, Natrium-bis-(trimethylsilyl)-amid, Natrium-bis-(trimethylsilyl)-amid-Lösung (in THF, in Toluol), Natriumbitartrat (Weinsäure Mononatriumsalz), Natrium-2 bromethansulfonat, Natrium 1-butansulfonat, Natrium 1-butanthiolat, Natriumtetr.-butoxid-Lösung (in THF), Natrium-tetr.-butoxid, Natrium-butyrate, Natriumcarbonate, Natriumcarbonat Monohydrat, Natriumcarbonat Decahydrat, Natrium-chloracetat, Natrium-2-chlor-ethansulfonat Monohydrat, Natrium-2-chlorpropionat, Natriumcholat Hydrat (Cholsäure Natriumsalz), Natriumcitrat dibasisch Sesquihydrat, Natriumcitrat monobasisch, Natriumcitrat tribasisch Dihydrat, Natriumcitrat tribasisch Hydrat, Natrium-cobalt-carboran, Natriumcyanat, Natrium N-cyclohexylsulfamat, Natriumcyclopentadienylid, Natrium-1-decansulfonat, Natriumdichloracetate, Natriumdichlorisocyanurat, Natriumdicyanamid, Natrium 2'-dicyclohexylphosphino-2,6-dimethoxy-1,1'-biphenyl-3-sulfonat Hydrat, Natriumdiethyldithiocarbamat Trihydrat, Natriumdiformylamid, Natrium-2,3-dimercaptopropansulfonat Monohydrat, Natriumdimethyldithiocarbamat, Natriumdimethyldithiocarbamat-Lösung, Natrium-diphenylamin-4-sulfonat, Natrium-1-dodecansulfonat, Natriumdodecylbenzolsulfonat, Natriumdodecylsulfat, Natriumdodecylsulfat-d25 Natriumsalz, Natrium-1,2-ethandisulfonat, Natrium-ethanthiolat, Natriumethoxid, Natriumethoxid-Lösung (in Ethanol), Natrium-2-ethylhexanoat, Natrium-2-ethylhexyl-sulfat, Natriumformiate, Natrium-fumarat dibasisch, Natrium-glyoxylat monohydrat, Natrium-1-heptansulfonat Monohydrat, Natrium-1-hexadecansulfonat, Natrium-1,1,1,5,5,5-hexafluoracetylacetonat, Natrium-1-hexansulfonat monohydrat, Natrium-4-hydroxy-benzoat, Natrium-2-hydroxybutyrat, Natrium-(S)-3-hydroxybutyrat Natriumsalz, Natrium-2-hydroxyethoxy-d4-acetat- d2 , Natrium-hydroxymethansulfinat Hydrat, Natriumiminodiacetat dibasisch Hydrat, Natrium-iminodiacetat dibasisch Monohydrat, Natrium-iodoacetat, Natrium-isopropylcyclopentadienid, Natriumisovalerat-1-13C, Natrium-Lactate, Natrium-Lactate-Lösung, Natrium-malonat dibasisch, Natrium-malonat dibasisch Monohydrat, Natrium-mesoxalat Monohydrat, Natrium-methansulfinat, Natrium-methansulfonat, Natriummethansthiolat, Natrium-methanthiosulfonat, Natrium-methoxid, Natrium-methoxid-Lösung (in Methanol), Natrium-3-methyl-2-oxobutyrat, Natrium-3-methyl-2-oxovalerat, Natrium-4-methyl-2-oxo-valerat, Natrium-2-methyl-2-propanthiolat, Natriummethylsulfat Natriumsalz, Natrium-4-methylvalerat-1-13C, Natriummyristylsulfat, Natrium-1-naphthalinsulfonat, Natrium-2-naphthalinsulfonat, Natrium-3-nitrobenzoat, Natrium-n itromalonaldehyd Monohydrat, Natrium-1-nonansulfonat, Natrium-octanoate, Natrium-1-octansulfonat, Natriumoctylsulfat, Natrium-oleat, Natriumoxalate, Natrium-2-oxobutyrat, Natrium-2-oxohexanoat Natriumsalz, Natriumpentamethylcyclopentadienylid-Lösung (inTHF), Natrium-1-pentansulfonat, Natrium-1-pentansulfonat Monohydrat, Natrium-tetr.-pentoxid, Natrium-tetr.pentoxid-Lösung (in THF), Natriumpercarbonat , Natrium-phenolat Trihydrat, Natrium-phenylpyruvat, Natrium-1-propansulfonat Monohydrat, Natrium-2-propansulfonat Monohydrat, Natrium-1-propanthiolat, Natrium-2-propanthiolat, Natriumpropionate, Natriumpyruvate, Natriumrhodizonat dibasisch, Natriumsalicylat, Natrium-styrol-4-sulfonat Natriumsalz Hydrat, Natrium-succinat dibasisch Hexahydrat, Natrium-succinat dibasisch, Natrium-L-tartrat dibasisch Dihydrat, Natriumtetraethylborat, Natrium-tetrakis-[3,5-bis-(trifluormethyl)-phenyl]-borat, Natrium-tetrakis-(4-fluorphenhyl)-borat Dihydrat, Natriumtetrakis-(1-imidazolyl)-borat, Natriumtetraphenylborat, Natriumthiocyanat, Natriumthioglykolat, Natriumthiomethoxid, Natriumthiomethoxid-Lösung (in Wasser), Natrium-p-toluolsulfinat, Natrium-p-toluolsulfinat Hydrat, Natrium-p-toluolsulfonat, Natriumtriacetoxyborhydrid, Natriumtrichloracetat, Natriumtriethylborhydrid-Lösung (in THF, Toluol), Natrium-trifluoracetate, Natriumtrimethoxyborhydrid, Natrium-trimethylacetat Hydrat, Natrium-trimethylsilanoat, Natrium-trimethylsilanoat-Lösung, Natrium-4-vinyl-benzolsulfonat, Natrium-vinylsulfonat-Lösung (in Wasser), Natriumxylolsulfonat-Lösung (in Wasser)
Kalium (K): Kaliumacetat, Kalium-4-acetylphenyltrifluoroborat , Kaliumallyltrifluoroborat , Kaliumantimon(III)-oxid-L-tartrat Hydrat, Kaliumantimonyltartrat Trihydrat , Kaliumbenzoat, Kalium-benzofuranyl-2-trifluoroborat, Kalium-benzofurazan-5-trifluoroborat, Kaliumbenzothiophen-2-yl-2-trifluoroborat, Kalium-[4-(benzylamino-1-carbonyl)-phenyl]-trifluoroborat, Kalium-4-(benzyloxy)-phenyltrifluoroborat, Kaliumbenzyltrifluoroborat, Kaliumcarbonat, Kalium-3,5-bis-(trifluormethyl)- phenyltrifluoroborat, Kaliumbis-(trimethylsilyl)-amid , Kalium-bis-(trimethylsilyl)-amid-lösung ??? (in THF, Toluol), Kalium-1-(Boc)-1H-indol-2-trifluorborat, Kalium-(brommethyl)-trifluoroborat, Kalium-4-bromphenyltrifluoroborat, Kalium-trans-3-brom-1-propenyltrifluoroborat, Kalium-2-brompyridin-3-trifluoroborat, Kalium-6-brompyridin-3-trifluoroborat, Kalium-5-bromthiophenyl-2-trifluoroborat, Kalium-(2Z)-2-buten-2-yltrifluoroborat, Kalium-tetr. butoxid, Kalium-tetr. butoxid-Lösung (in tetr. Butanol, THF), Kalium-butylaminomethyltrifluoroborat, Kalium-4-tetr.-butylphenyltrifluoroborat, Kaliumbutyltrifluoroborat, Kaliumcarbonate, Kaliumcarbonat-Natriumcarbonat-Mischung, Kalium-3-carboxyphenyltrifluoroborat, Kalium-4-carboxyphenyltrifluoroborat, Kalium-4-chlorphenyltrifluoroborat, Kalium-2-chlorpyridin-3-trifluoroborat, Kalium-5-chlorpyridin-3-trifluoroborat, Kalium-6-chlorpyridin-3-trifluoroborat, Kalium-N-chlor-p-toluolsulfonamid, Kalium-citrat tribasisch tribasisch Monohydrat, Kaliumcyanat , Kalium-4-cyclohexyl-butyrat, Kaliumcyclopentytrifluoroborat, Kalium-cyclopropyltrifluoroborat, Kalium-2-(3,5-di-tetr.-butyl-2-hydroxybenzylidenamion)-2,2-diphenyl-acetat, Kaliumdichloracetat, Kaliumgoldcyanid, Kalium-[4-(diethylamin-1-carbonyl)-phenyl]-trifluoroborat, Kalium-2,4-difluorphenyltrifluoroborat, Kalium-2,6-difluorphenyltrifluoroborat, Kalium-2,6-dimethoxyphenyltrifluoroborat, Kalium-(N,N-dimethylaminomethyl)-trifluoroborat, Kalium-4-(N,N-dimethylamino)-phenyltrifluoroborat, Kalium-(3,3-dimethybutyl))-trifluoroborat, Kalium-[4-(N,O-dimethylhydroxylaminocarbonyl)phenyl]-trifluoroborat, Kalium-2,6-dimethylphenyltrifluoroborat, Kalium-2,5-dimethylthiophen-3-trifluoroborat, Kalium-diphenylphosphid-Lösung, Kaliummethoxid, Kaliummethoxid-Lösung, Kalium-ethyltrifluorcarborat, Kaliumethylxanthogenat, Kalium-2-fluor-5-formylphenyltrifluoroborat, Kalium-3-fluorphenyltrifluoroborat, Kalium-4-fluorphenyltrifluoroborat, Kalium-6-fluorpyridin-3-trifluoroborat, Kaliumformiat, Kalium-d-formiat, Kalium-3-formilphenyltrifluoroborat, Kalium-4-formilphenyltrifluoroborat, Kalium-2-furantrifluoroborat, Kalium-furan-3-trifluoroborat, Kaliumgold(III)-chlorid, Kaliumhydrogenphthalat, Kaliumhydrogentartrat monobasisch, Kalium-4-(hydroxymethyl)-phenyltrifluoroborat, Kalium-3-hydroxyphenyltrifluoroborat, Kalium-indigotetrasulfonat, Kaliumindigotrisulfonat, Kalium-2-iod-5-methylbenzolsulfonat, Kalium-(iodomethyl)-trifluoroborat, Kalium-4-iodophenyltrifluoroborat, Kalium-ionophor II, Kalium-2-isocyanoacetat, Kaliumisopropenyltrifluoroborat, Kaliumisopropentrifluoroborat, Kaliummethansulfonat, Kaliummethoxid, Kaliummethoxid-Lösung, Kalium-2-methoxyphenyltrifluoroborat, Kalium-4-methoxyphenyltrifluoroborat, Kalium-trans-3-methoxy-1-propenyltrifluoroborat, Kalium-2-methoxypyridin-3-trifluoroborat, Kalium-2-methoxypyridin-5-trifluoroborat, Kalium-3-methyl-2-buten-2-yltrifluoroborat, Kalium-3,4-(methylendioxy)-phenyltrifluoroborat, Kalium-(4-methyl-1-piperazinyl)-metyltrifluoroborat, Kalium-2-methyl-1-propenyltrifluoroborat, Kalium-5-methyl-2-thiophentrifluoroborat, Kalium-methyltrifluoroborat, Kalium-4-(morpholin-4-carbonyl)phenyltrifluoroborat, Kalium-2-naphtalintrifluoroborat, Kalium-natriumtartrat-Tetrahydrat, Kaliumnitrate , Kalium-(2-nitrophenyl)-trifluoroborat, Kalium-3-nitrophenyltrifluoroborat, Kalium-octyltrifluoroborat, Kaliumoleat, Kaliumoxalat Monohydrat, Kalium-α-oxo-7-azzaindol-3-acetat, Kaliumpalmitate, , Kaliumpalmitat Kaliumsalz, Kaliumpentamethylcyclopentadienylid, Kalium-tetr.-pentoxid-Lösung, Kaliumphenoxymethyltrifluoroborat, Kalium-[4-(phenylaminomethyl)-phenyl]-trifluoroborat, Kalium-(phenylethinyl)-trifluoroborat, Kaliumphenylethyltrifluoroborat, Kaliumphenyltrifluoroborat, Kaliumphtalat monobasisch, Kalium-1H-pyrazol-3-trifluoroborat, Kalium-pyridin-3-trifluoroborat, Kalium-4-pyridintrifluoroborat, Kalium-pyrimidin-5-trifluoroborat, Kaliumrhodizonat, Kalium-sec.-butyltrifluoroborat, Kalium-trans-styrylrifluoroborat, Kaliumtartrat-dibasisch Hemihydrat, Kaliumtetrabromoaurat(III) Hydrat , Kalium-1-(tetrahydro-2H-pyran-2-yl)-1H-pyrazol-4-trifluoroborat, Kalium-tetrakis-(4-chlorphenyl)-borat, Kalium-tetrakis-(2-thienyl)-borat, Kaliumtetraphenylborat, Kaliumthioacetat, Kaliumthiocyanate, Kalium-2-thiophentrifluoroborat, Kalium-3-thiophentrifluoroborat, Kaliumtitanoxid-oxalat Dihydrat, Kalium-p-toluolthiosulfonat, Kalium-o-toluoltrifluoroborat, Kalium-p-toluoltrifluoroborat, Kalium-triethylborhydrid-Lösung, Kalium-trifluoracetat, Kalium-2-(trifluormethyl)-phenyltrifluoroborat, Kalium-4-(trifluormethyl)-phenyltrifluoroborat, Kalium-trimethylsilanolat, Kaliumtrioxalatochrom(III) Trihydrat, Kalium-triphenylborhydrid-Lösung (inTHF), Kaliumvinyltrifluoroborat
Rubidium (Rb): Rubidiumcarbonat, Rubidiumnitrat, Rubidiumtetraphenylborat
Cäsium (Cs): Cäsiumacetat, Cäsiumbicarbonat, Cäsiumcarbonat, Cäsiumformiat, Cäsiummethansulfonat, Cäsiumnitrat , Cäsiumoxalat, Cäsiumpivalat (Cäsiumtrimethylacetat), Cäsiumtetraphenylborat
Beryllium (Be): Berylliumnitrat-Lösung , Berylliumacetat
Magnesium (Mg): Magnesiumcitrat, Magnesiumethylat, Magnesiumgluconat, Magnesiumnitrat, Magnesiumacetat, Magnesium-acetylacetonat (Mg(acac)), Magnesium-bis-(diisopropyl)-amid-lösung, Magnesium-bis-(hexamethyldisilazid), Magnesium-bis-(monoperoxyphtalat) Hexahydrat, Magnesiumbromid-ethyletherat , Magnesiumchlorid-triethylamin-Lösung(in Methanol), Magnesium-di-tetr.-butoxid, Milchsäure Magnesiumsalz, Magnesiummethoxid-Lösung(in Methanol), Magnesium-methylcarbonat-Lösung (Dimethylformamid), Magnesium-monoperoxyphtalat, Magnesiumphtalocyanin, Magnesium-stearat (Stearinsäure Magnesiumsalz), Magnesiumtrifluormethansulfonat
Calcium (Ca): Calciumacetat Monohydrat, Calciumacetat Hydrat, Calciumacetylacetonat Hydrat, Calcium-L-ascorbat Dihydrat, Calciumcarbonate, Calciumcitrat Tetrahydrat, Calcium-2-ethylhexanoat, Calcium-D-gluconat-Monohydrat, Calcium-α-D-heptagluconat-Hydrat, Calciumisopropoxid, Calcium-L-lactat Hydrat, Calciumethylat, Calciumnitrat Hydrate , Calciumnitrate, Calciumoxalat, Calciumoxalat Monohydrat, Calciumoxalat Hydrat, Calciumpropionat, Calcium-2,2,6,6-tetramethyl-3,5-heptandionat, Calciumthiocyanat Tetrahydrat
Strontium (Sr): Strontiumacetat, Strontiumacetylacetonat Hydrat, Strontiumcarbonat, Strontiumisopropoxid, Strontiumnitrat , Strontiumoxalat, Strontium-tetramethylheptandionat
Barium (Ba): Bariumnitrat, Bariumacetat, Barium-acetylacetonat, Bariumtetr. Butoxid, Bariumcarbonat, Barium-2-cyanethylphosphat Hydrat, Barium-diphenylamin-4-sulfonat, Barium-2-ethylenhexanoat, Barium isopropoxid, Barium-2,2,6,6-tetramethyl-3,5-heptandionat Hydrat, Bariumthiocyanat , Bariumtrifluormethansulfonat
Scandium (Sc): Scandium(III)-acetat Hydrat, Scandium-acetylaceton Hydrat, Scandiumosipropoxid, Scandium(II)-nitrat Hydrat , Scandium(III)-(2,2,6,6-tetramethyl-3,5-heptandionat) Hydrat
Yttrium (Y): Yttriumnitrat, Yttrium(III)-acetat, Yttrium(III)-acetylacetonat (Y(acac)), Yttrium(III)-butoxid-Lösung (in Toluol), Yttrium(III)-carbonat Hydrat, Yttrium(III)-2-ethylhexanoat, Yttrium(III)-isopropoxid (in Toluol), Yttrium(III)-isopropoxid-oxid, Yttrium(III)-2,2,6,6-tetramethyl-3,5-heptandionat, Yttriumfluoracetat, Yttrium(III)-trifluoracetat, Yttrium-trifluormethansulfonat
Lanthan (La): Lanthanacetat Hydrat, Lanthan(III)-acetylacetonat Hydrat, Lanthan(III)-carbonat Hydrat, Lanthan(III)-isopropoxid, Lanthan(III)-nitrat Hydrate, Lanthan(III)-oxalat Hydrat, Lanthan-trifluormethansulfonat, Lanthan-trifluormethansulfonat Hydrat
Titan (Ti): Titanacetylacetonat, Tetraethylothotitanat, Tetrapropylorthotitanat, Titan(IV)-bis-(ammoniumlactato)-dihydrid-Lösung, Titan(IV)-butoxid, Titan(IV)-tetr. Butoxid, Titan(III)-chlorid-Tetrahydrofuran-Komplex, Titan(IV)-chlorid-Tetrahydrofuran-Komplex, Titandiisopropoxid-bis-(acetylacetonat), Titan(IV)-ethoxid, Titan(IV)-2-ethylhexyloxid, Titan(IV)-isopropoxid, Titan(IV)-methoxid, Titan(IV)-oxidacetylacetonat (TiO(acac), Titan(IV)-phtalocyanin-dichlorid, Titan(IV)-propoxid, Titan(IV)-(triethanolaminato)-isopropoxid-Lösung, Titanylphthalocyanin,
Zirconium (Zr): Zirkoniumacetat-Lösung (in Essigsäure), Zirkonium(IV)-acetylacetonat, Zirkoniumacrylat, Zirkonium (IV)-bis-(diethylcitrato)-dipropoxid, Zirkonium-bromnorbornanlacton-carboxylat-triacrylat , Zirkonium(IV)-butoxid, Zirkonium(IV)-tetr.-butoxid, Zirkonium(IV)carbonat basisch, Zirkonium-carboxyathylacrylat (in n-propanol), Zirkonium(IV)-chlorid Tetrahydrofuran-Komplex , Zirkonium(IV)-ethoxid, Zirkonium(IV)-isopropoxid Isopropanol Komplex, Zirkonium(IV)-Propoxid-Lösung (in n-Propylalkohiol), Zirkonium(IV)-2,2,6,6,-tetramrthyl-3,5-heptandionat, Zirkonium(IV)-trifluoracetylacetonat
Hafnium (Hf): Hafnium(IV)-n-butanolat, Hafnium(IV)-tetr.-butanolat, Hafnium-carboxyethylacrylat, Hafnium(IV)-chlorid-Tetrahydrofuran-Komplex, Hafniumisopropoxid-Isopropanol-Addukt, Hafnium (IV)-trifluormethansulfonat Hydrat
Vanadium (V): Vanadium(III)-acetylacetonat, Vanadium(III)-chlorid-Tetrahydrofuran-Komplex , Vanadium(V)-oxytriethoxid, Vanadium(V)-oxytriisopropoxid, Vanadium(V)-oxytripropoxid, Vanadyl-acetylacetonat, Vanadyl-2,3-naphtalocyanin, Vanadyl-2,1120,29-tetra-tetr-butyl-2,3-naphtalocyanin, Vanadyl-3,10,17,24-tetra-tetr-butyl-1,8,15,22-tetrakis-(dimethylamino)-29H,31H-phtalocyanin, Vanadyl-2,9,16,23-tetraphenoxy-29H,31H-phtalocyanin
Niob (Nb): Niob(V)-ethoxid
Tantal (Ta): Tantal(V)-butoxid, Tantal(V)-ethoxid, Tantal(V)-methoxid
Chrom (Cr): Chrom(II)-acetat Monohydrat, Chrom(III)-acetat, Chrom(III)-acethylacetonat (Cr(acac)3), Chrom(III)-Chlorid-THF-Komplex , Chromon , Chromon-3-carbonsäure , Chromotrop (Farbstoffe)
Molybdän (Mo): Molybdän(II)-acetat Dimer, Molybdän-hexacarbonyl , Molybdänyl-acethylacetonat
Wolfram (W): Wolfram-hexacarbonyl
Mangan (Mn): Mangan(II)-acetat, Mangan(II)-acetat Tetrahydrat, Mangan(III)-acetat Dihydrat, Mangan(II)-acetylacetonat, Mangan(III)-acetylacetonat, Mangan-bis-(trifluormethansulfonat) , Mangan(II)-carbonat, Mangan(II)-carbonat Hydrat, Mangancarbonyl, Mangan(II)-formiat Hydrat, Mangan(II)-1,1,1,5,5,5-hexafluoracetylacetonat Trihydrat, Mangan(II)-nitrat Hydrate , Mangan(II)-phtalocyanin , Mangan(III)-phtalocyanin-chlorid
Rhenium: Methylrheniumtrioxid (MTO), Rhenium-Komplexe.
Eisen (Fe): Eisencitrat, Eisenfurmat, Eisengluconat, Ammoniumeisencitrat, Ammoniumeisensulfat, Eisen(II)-acetat, Eisen(II)-acetylacetonat, Eisen(III)-acetylacetonat, Eisen(II)-ethylendiammoniumsulfat Tetrahydrat, Eisen(II)-furmarat, Eisen(II)-lactat Hydrat, Eisen(II)-oxalat Dihydrat, Eisen(III)-oxalat Hexahydrat, Eisen(o)-pentacarbonyl , Eisenphtalocyanin , Eisen(III)-2,2,6,6-tetramethyl-3,5-heptandionat, Eisen(III)-p-Toluolsulfonat Hexahydrat, Eisen(II)- trifluormethansulfonat
Ruthenium (Ru): Ruthenium(III)-acetylacetonat,
Osmium: Osmium-Komplexverbindungen
Kobalt (Co): Cobalt(II)-acetat, Cobalt(II)-acetylacetonat, Cobalt(III)-acetylacetonat, Cobalt(II)-benzoylacetonat, Cobalt(II)-carbonat Hydrat, Cobaltcarbonyl, Cobalt(II)-cyanid Dihydrat, Cobalt(II)-2-ethylenhexanoat-Lösung (in Lösungsbenzin), Cobalt(II)-1,2,3,4,8,9,10,11,15,16,17,18,22,23,24,25-hexadecafluor-29H,31H-phtalocyanin , Cobalt(II)-1,1,1,5,5,5-hexafluoracethylacetonat Hydrat, Cobalt(II)-2,3-naphtalocyanin, Cobaltnaphthenat, Cobalt(II)-oxalat Dihydrat, Cobalt(II)-phtalocianin, Cobalt(II)-thiocianat ,
Rhodium (Rh): Rhodium(II)-acetat Dimer, Rhodium(III)-acetylacetonat, Rhodium(II)-heptafluorbutyrat-Dimer, Rhodium(II)-hexanoat Dimer, Rhodium(II)-oktanoat Dimer, Rhodium(II)-trifluoracetat Dimer, Rhodium(II)-trimethylacetat Dimer, Rhodium(II)-triphenylacetat Dimer
Iridium (Ir): Iridiumacetylacetonat
Nickel (Ni): Nickel(II)-acetat Tetrahydrat, Nickel(II)-acetylacetonat, Nickel(II)-bromid Diethylenglykoldimethylether-Komplex , Nickel(II)-bromid Dimethoxyethanr-Komplex , Nickel(II)-carbonat basisch Tetrahydrat, Nickel(II)-carbonat basisch Hydrat Nickelchlorid-Dimethoxyethan-Addukt , Nickel(II)-4-cyclohexyl-butyrat, Nickel(II)-2-ethylhexonat, Nickel(II)-1,1,1,5,5,5-hexafluoracetylacetonat Hydrat , Nickel(II)-1,4,8,11,15,18,22,25-octabutoxy-29H,31H-phtalocyanin, Nickel(II)-5,9,14,18,23,27,32,36-octabutyloxy-2,3-naphtalocyanin, Nickel(II)-octanoat Hydrat, Nickel(II)-oxalat Dihydrat, Nickel(II)-phtalocyanin , Nickel(II)-phtalocyanin-tetrasulfonsäure Tetranatriumsalz , Nickel(II)-2,2,6,6-tetramethyl-3,5,heptandionat)
Palladium (Pd): Palladium(II)-acetate, Palladium(II)-acetylacetonat, Palladium(II)-[1,3,-bis-(diphenylphosphino-)propan]-bis-(benzonitril)-bis-tetrafluorboat , Palladium(II)-chlorid-diacetonitril-Komplex , Palladium-(π-cinnamyl)-cjlorid Dimer, Palladium(II)-hexafluoracetylacetonat, Palladiumpivalat, Palladium-propionat, Palladium(II)-tetrafluoroborat Tetraacetonitril-Komplex , Palladium(II)-tetrafluouracetat
Platin (Pt): Platin(II)-acetylacetonat, Platin(II)- Platin-octaethyl-porphyrin , Chloroplatin(IV)-säure
Kupfer (Cu): Kupfer(I,II)-acetate, Kupfer(II)-acetat-1,2-bis-diphenylphosphino)-ethan , Kupfer(II)-acetylacetonat (Cu(acac)2), Kupfer-bis-(6,6,7,7,8,8,8-heptafluor-2,2-dimethyl-3,5-oktandionat, Kupfer(I)-bromid-dimethylsulfid-Komplex , Kupfer(II)-tetr.-butylacetoacetat, Kupfer(II)-4-cyclohexyl-butyrat, Kupfer(II)-carbonat basisch, Kupfer(II)-3,5-diisopropylsalicylat Hydrat, Kupfer-2-[(diphenylphosphino)-benzyldenamino]-3,3-dimethylbutyrat,Trinatrium-triflat]-Komplexs, dimer , Kupfer(II)-2-ethylheyanoat, Kupfer(II)-formiat hydrat (Ameisensäure Kupfer(I)-salz Hydrat), Kupfer(II)-D-gluconat, Kupfer(II)-1,2,3,4,8,9,10,11,15,16,17,18,22,23,24,25-hexadecafluor-29H,31H-phtalocianin , Kupfer(II)-1,1,1,5,5,5-hexafluoracetylacetonat Hydrat, Kupferiodid-Dimethylsulfid-Komplex , Kupfer(II)-methoxid, Kupfer(I)-3-methylsalicylat, Kupfer(II)-2,3-naphtalocyanin , Kupfer(II)-1,4,8,11,15,18,22,25-octabutoxy-29H,31H-phtalocyanin , Kupfer(II)-5,9,14,18,23,27,32,36-octabutyloxy-2,3-naphtalocyanin , Kupfer(II)-2,3,9,10,16,17,23,24-octakis-(octyloxy)-29H,31H-phtalocyanin , Kupfer(II)-phtalocyanin , Kupfer phtalocyanin-3,4',4",4'''-tetrasulfonsäere Tetranatriumsalz, Kupfer(II)- phtalocyanin-tetrasulfonsäure Tetranatriumsalz, Kupfer(II)-tartrat (Weinsäure Kupfer(I)-salz), Kupfer(II)-4,4',4",4'''-tetraaza-29H,31H-phtalocyanin , Kupfer(II)-2,9,16,23-tetra-tetr-butyl-29H,31H-phtalocyanin , Kupfer(II)-2,2,6,6-tetramethyl-3,5-heptandionat, Kupfer(I)-thiophen-2-carboxylat, Kupfer(II)-trifluoracetat, Kupfer(II)-trifluoracetylacetonat, Kupfer(II)-trifluormethansulfonat , Kupfer(II)-trifluormethansulfonat-Benzol-Komplex, Kupfer(II)-trifluormethansulfonat-Toluol-Komplex,
Silber (Ag): Silberacetat, Silber(I)-acetylacetonat, Silberbenzoat, Silber-bis-(trifluormethansulfonyl)-imid, Silbercarbonat, Silbercitrat Hydrat, Silbercyanat , Silber-4-cyclohexyl-butyrat, Silberdiethyldithiocarbamat , Silberheptafluorbutyrat, Silberlactat, Silber-methansulfonat, Silberpentafluorpropionat, Silber(II)-picolinat, Silber(I)-sulfadiazin, Silber p-toluolsulfonat, Silber-trifluoracetat, Silberthiocyanat , Silber-trifluormethansulfonat,
Gold (Au): Auranofin , Natriumaurothiomalat
Zink (Zn): Zinkacetate, Zink-acethylacetonat Hydrat, Zinkacrylat, Zink-70-Zn-L-aspartat , Zink-bis-(2,2,6,6-tetramethyl-3,5-heptandionat), Zinkchlorid-Tetrahydrofuran-Komplex , Zinkcitrat tribasisch Dihydrat, Zink-di-bis-(trifluormethylsulfonyl)-imid , Zink-3,5-di-tetr.-butylsalicylat, Zinkdiethyldithiocarbamat, Zinkdimethyldithiocarbamat , Zink-70-Zn-glyconat, Zink-1,2,3,4,8,9,10,11,15,16,17,18,22,23,24,25-hexadecafluor-29H,31H-phtalocianin , Zink-hexafluoracetylacetonat Dihydrat, Zinkmethacrylat, Zinkmethoxid, Zinknaphthenat, Zink-1,4,8,11,15,18,22,25-octabutoxy-29H,31H-phtalocianin , Zink-2,3,9,10,16,17,23,24-octakis-29H,31H-phtalocianin , Zinkoxalat Hydrat, Zink-phtalocyanin , Zinkstearat, Zink-2,11,20,29-tetra-tetr-butyl-2,3-naphtalocyanin , Zink-2,9,16,23-tetra-tetr-butyl-29H,31H-phtalocianin , Zink(II)-tetranitrophtalocyanin , Zink p-toluolsulfonat Hydrat, Zink-trifluoracetat Hydrat, Zink-trifluormethansulfonat, Zink-undecylenat
Cadmium (Cd): Cadmiumacetat Hydrat, Cadmiumacetat Dihydrat, Cadmiumacetylacetonat Hydrat, Cadmiumcarbonat, Cadmiumnitrat Tetrahydrat
Quecksilber (Hg): Quecksilber(II)-acetat, Quecksilber(I)-nitrat Dihydrat , Quecksilber(II)-nitrat Monohydrat, Quecksilber(II)-nitrat-Lösung (in Wasser), Quecksilber(II)-tetrathiocyanatocobaltat(II), Quecksilber(II)-thiocyanat, Quecksilber(II)-trifluoracetat, Quecksilber(II)-trifluormethansulfonat, Quecksilber(II)-fulminat
Bor (B): Organoborane, Organoboronsäuren und Organoboronsäureester, 9-Borabicyclo[3.3.1]nonan-Lösung (in Hexan-Fraktion, in THF), 9-Borabicyclo[3.3.1]nonan Dimer, Borabicyclo[3.3.1]nonyl-trifluorsulfonat-Lösung (in Hexan-Fraktion), Boramere (Poly-[(2,5-didecycloxy-1,4-phenylen)-(2,4,6-triisopropyl-phenylboran)], Diphenyl-Endgruppen), Boran-Ammoniak-Komplex, Boran-tetr.-Butylamin-Komplex, Boran-Di-tetr.-Butylphosphin-Komplex, Boran-N,N-diethylanilin-Komplex, Boran-N,N-diisopropylethylamin-Komplex, Boran-Dimethylamin-Komplex, Boran-dimethylsulfid-Komplex, Boran-dimethylsulfid-Komplex-Lösung (in Diethylether, Methylenchlorid, THF, Toluol), Boran-diphenylphosphin-Komplex, Boran-N-methylmorpholin-Komplex, Boran-Morpholin-Komplex, Boran-Pyridin-Komplex, Boran-Tetrahydrofuran-Komplex-Lösung (in THF), Boran-d3-THF-Komplex-Lösung (in THF), Boran-triethylamin-Komplex, Borantrimethylamin-Komplex, Boran-Triphenylphosphin-Komplex, 4-Borono-D-phenylalanin, 4-Borono-L-phenylalanin, 4-Borono-DL-phenylalanin, Borontrifluorid-Methanol-d4-Komplex, Bor-subphtalocyanin-chlorid, Bortribromid-Lösung (in Heptan, Hexan-Fraktion, Methylenchlorid), Bortrichlorid-Lösung (in Toluol, Heptan, Hexan-Fraktion, Methylenchlorid, in α-Xylol), Bortrichlorid-dimethylsulfid-Komplex, Bortrichlorid-dimethylsulfid-Komplex-Lösung (in Methylenchlorid), Bortrifluorid-Acetonitril-Komplex-Lösung, Bortrifluorid-tetr.-butylmethyletherat, Bortrifluorid-Dibutylether-Komplex, Bortrifluoriddiethyletherat, Bor-10B-trifluorid-Diethylether-Komplex, Bortrifluorid-Dimethylsulfid-Komplex, Bortrifluorid-Essigsäure-Komplex, Bortrifluorid-Ethylamin-Komplex, Bortrifluoridin Methanol, Bortrifluorid-Methanol-Komplex-Lösung, Bortrifluorid-methyletherat, Bortrifluorid-Tetrahydropfuran-Komplex, or-tris-(trifluoracetat)-Lösung
Phosphor (P): Phosphazen-Base P2-t-Bu-Lösung (in THF), Phosphazen-Base P4-t-Bu-Lösung (in Hexan,), Phosphazen-Base P1-t-Bu-tris-(tetramethylen), Phosphazen-Base P2-Et, Phosphazen-Base P1-t-Oct, Phosphazen-Base P4-t-Oct-Lösung (in Hexan), Phosphocholinchlorid Calciumsalz Tetrahydrat, Phospho(enol)brenztraubensäure Cyclohexylaminsalz, Phospho-enolpyruvat Monokaliumsalze, Phosphanoameisensäure Trinatriumsalz, 2-Phosphanobuttersäure-triethylesther, 4-Phosphonocrotonsäuretriethylester, (12-Phosphonododecyl)-phosphonsäure, Phosphonoessigsäure, Phosphonoessigsäure-P,P-bis-(2,2,2-trifluorethyl)methylester, Phosphonoessigsäure-P,P-dimethyl-tetr.-butylester, Phosphonoessigsäure-P,P-dimethyl-ethylester, Phosphonoessigsäure-triethylestere, Phosphonoessigsäure-trimethylester, 16-Phosphonohexadecansäure, 6-Phosphonohexansäure, N-(Phosphonomethyl)-glycine, N-(Phosphonomethyl)-glycin Monoisopropylaminsalz-Lösung, N-(Phosphonomethyl)-iminodiessigsäure Hydrat, (8-Phosphono-octyl)-phosphonosäure, 4-phosphonooxy-TEMPO (-2,2,6,6-tetramethyl-1-piperidinyloxy), 3-Phosphono-propionsäure, 2-Phosphono-propionsäure-triethylester, 3-Phosphonopropionsäuretriethylester, 11-Phosphonoundecansäure, Phosphorsäure-bis-(dimethylamid)-chlorid, Phosphorsäure-cyclopropylmethyl-diethyl-ester, Phosphorsäure-dichloriddimethylamid, Phosphorsäure-diethyl-3-butenylester, Phosphorsäurediphenylester-azid, Phosphorsäure-diphenylester-chlorid
Aluminium (Al): Aluminiumacetat basisch, Aluminiumacetylacetonat (Al(acac)3), Aluminiumbutoxid, Aluminium-tetr-butoxid, Aluminium-sec.-butoxid, Aluminium-sec.-butoxid-Lösung (in Methylenchlorid), Aluminiumchlorid-THF-Komplex , Aluminiumethoxid, Aluminiumisopropoxid, Aluminium-L-lactat, Aluminium-monostearat, Aluminium-2,3-naphtalocyanin-chlorid , Aluminiumphenolat, Aluminiumphtalocyanin-hydroxidd , Aluminium-tetrakis-(4-chlorphenyl)porphin-bis-tetrahydrofuran-tetracarbonylcobaltat , Aluminium-1,8,15,22-tetrakis-(phenylthio)-29H,31H-phtalocyanin-chloridt , Aluminium-2,2,6,6-tetramethyl-3,5-heptandionat
Gallium (Ga): Gallium(III)-acetylacetonat, Gallium(III)-nitrat Hydrat , Gallium(III)-phtalocyanin-chlorid
Indium (In): Indium(III)-acetat, Indium(III)-acetat Hydrat, Indium(III)-acetylacetonat, Indium(III)-nitrat Hydrat, Indium(III)-phtalocyanin-chlorid, Indium(II)-trifluormethansulfonat, Indium(III)-tris-(trifluormethansulfonimid)
Thallium (Tl): Thallium(I)-acetat, Thallium(III)-acetat, Thallium(I)-acetylacetonat, Thallium(I)-carbonat, Thallium(I)-ethoxid, Thallium(I)-formiat, Thallium(I)-nitrat, Thallium(I)-nitrat Trihydrat, Thallium(III)-trifluoracetat
Silicium (Si): Silicium-2,3-naphtalocyanin-dichlorid, Silicium-2,3-naphtalocyanin-dihydroxid, Siliciumphtalocyanin-dichlorid, Siliciumphtalocyanin-dihydroxid , Siliciumtetraacetat, Silicium-2,9,16,23-tetra-tetr-butyl-29H,31H-phtalocianin-dihydroxid
Germanium (Ge): Germanium(II)-chlorid-Dioxan-Komplex , Germanium(IV)-ethoxid, Germanium(IV)-isopropoxid, Germanium(IV)-methoxid
Zinn (Sn): Zinn(II,IV)-acetat, Zinn(IV)-bis-(acethylacetonat)-bromid , Zinn(IV)-bis-(acethylacetonat)-chlorid, Zinn(IV)-tetr.-butoxid, Zinn(II)-2-ethylhexanoat, Zinn(II)-methansulfonat-Lösung (in Wasser), Zinn(II)-oxalat, Zinn(IV)-phtalocyanin-oxid , Zinn-trifluormrthansulfonat
Blei (Pb): Blei(II)-acetat Trihydrat, Blei(IV)-acetat, Blei(II)-acetylacetonat, Blei(II)-carbonat, Blei(II)-carbonat basisch, Blei(II)-methansulfonat-Lösung (in Wasser), Bleiphtalocyanin , Blei(II)-subacetat, Blei(II)-tetrakis-(4-cumylphenoxy)-phtalocyanin
Arsen (As): Arsenobetain
Antimon (Sb): Antimonigsäure-tripropylester
Wismut / Bismut (Bi): Bismut(III)-acetat, Bismut(III)-carbonat basish, Bismut(III)-citrat, Bismut(III)-gallat basisch Hydrat, Bismut-neodecanoat, Bismut(III)-nitrat Pentahydrat, Bismut(III)-salicylat basisch, Bismut(III)-trifluormethansulfonat
Selen (Se): Seleno-L-cystin, Seleno-DL-methionin-methyl-13C1, Selenophen
Tellur (Te): Verbindungen der Form R2Te, R2Te2, R4Te und R6Te (R jeweils Alkyl-, Aryl-), Diorganotellurdihalogenide R2TeX2 (R = Alkyl-, Aryl-; X = F, Cl, Br, I) und Triorganotellurhalogenide R3TeX (R = Alkyl-, Aryl-; X = F, Cl Br, I)
Cer (Ce): Cer(III)-acetat Hydrat, Cer(III)-acetylacetonat Hydrat, Cer(III)-carbonat Hydrat, Cer(III)-2-ethylhexanoat, Cer(III)-nitrat Hexahydrat, Cer(III)-oxalat Hydrat
Praseodym (Pr): Praseodym(III)-acetylacetonat Hydrat, Praseodym(III)-nitrat Hexahydrat, Praseodym (III)-trifluormethansulfonat
Neodym (Nd): Neodym(III)-acetat Hydrat, Neodym(III)-acetylacetonat Hydrat, Neodym(III)-carbonat Hydrat, Neodym(III)-isopropoxid, Neodym(III)-nitrat Hexahydrat , Neodym(III)- nitrat Hydrat
Samarium (Sm): Samarium(III)-acetat Hydrat, Samarium(III)-acetylacetonat Hydrat, Samarium(III)-isopropoxid, Samariumnitrat Hexahydrat , Samarium(III)-trifluormethansulfonat
Europium (Eu): Europium(III)-acetat Hydrat, Europium(III)-acetylacetonat Hydrat, Europium(III)-nitrat Pentahydrat , Europium(III)-nitrat Hydrat , Europium(III)-trifluoracetat, Europium (III)-trifluormethansulfonat, Europium(III)-tris-(d,d-dicampholymethanat), Europium(III)-tris-[3-(heptafluorpropylhydroxymethylen)-(-)camphorat], Europium (III)-tris-[3-(heptafluorpropyl-hydroxymethylen)-d-camphorat], Europium(III)-tris-[3-(trifluormethyl-ydroxymethylen)-d-camphorat]
Gadolinium (Gd): Gadolinium(III)-acetat Hydrat, Gadolinium(III)-acetylacetonat Hydrat, Gadolinium(III)- carbonat Hydrat, Gadolinium(III)-nitrat Hexahydrat , Gadolinium(III)-triethylentetraminhexaacetat Trinatriumsalz, Gadolinium(III)-trifluormethansulfonat, Gadolinium(III)-triisopropanolat
Terbium (Tb): Terbium(III)-acetat Hydrat, Terbium(III)-acetylacetonat Hydrat, Terbium(III)-nitrat Pentahydrat ,Terbium(III)-nitrat Hexahydrat ,Terbium(III)-2,2,6,6-tetramethyl-3,5-heptandionat, Terbium(III)-trifluormethansulfonat
Dysprosium (Dy): Dysprosium(III)-acetat Hydrat, Dysprosium(III)-nitrat Hydrat, Dysprosium(III)-trifluormethansulfonat
Holmium (Ho): Holmium(III)-acetat Hydrat, Holmium(III)-nitrat Pentahydrat , Holmium(III)-trifluormethansulfonat
Erbium (Er): Erbium(III)-acetat Hydrat, Erbium(III)-acetylacetonat Hydrat, Erbium(III)-nitrat Pentahydrat , Erbium(III)-2,2,6,6-tetramethyl-3,5-heptandionat, Erbium(III)-trifluormethansulfonat
Thulium (Tm): Thulium(III)-acetat Hydrat, Thulium(III)-nitrat Pentahydrat , Thulium(III)-trifluormethansulfonat
Ytterbium (Yb): Ytterbium(III)-acetat Hydrat, Ytterbium(III)-isopropoxid, Ytterbium(III)-nitrat Pentahydrat , Ytterbium(III)-trifluormethansulfonat, Ytterbium(III)-trifluormethansulfonat Hydrat,
Lutetium (Lu): Lutetium(III)-acetat Hydrat, Lutetium(III)-acetylacetonat Hydrat, Lutetium(III)-nitrat Hydrat , Lutetium(III)-trifluormethansulfonat
Wolfram (W): Wolfram-hexacarbonyl , und/oder
Actinium (Ac): Actinium(III)-oxalat

Im Fall von Rhenium sei angemerkt, dass Methylrheniumtrioxid (MTO) löslich in Wasser und organischen Lösungsmitteln ist. Rhenium-Komplexe sowohl mit einzelnen Metallzentren, als auch als Metallcluster sind bevorzugt. Bei diesen können Rhenium-Rhenium-Mehrfachbindungen teilweise auch in Form von Dreifach- oder Vierfachbindungen vorliegen. Eine Vierfachbindung existiert beispielsweise im Re2X82--Komplexion (X ist dabei ein Halogenatom oder eine Methylgruppe).

Beim 3D-Druck können Bindemittel und keramisches Pulver aufeinander abgestimmt werden. Der Binder muss dafür sorgen, dass die Pulverpartikel miteinander "verkleben" und der Grünling eine hinreichende Festigkeit erhält. Beim Aufbringen der Verfestigungszusammensetzung, die beispielsweise mittels Druckknopf aufgebracht wird, darf diese nicht verlaufen, sondern muss die Kontur exakt abbilden. Dazu ist es notwendig, dass diese in kurzer Zeit mit wenigen Partikeln des Pulverbetts reagiert. Der Anteil der organischen Additive sollte vorzugsweise so gering sein, dass kein gesonderter Entbinderungs-Prozess notwendig ist. Ziel ist es, den "gedruckten" Grünling unmittelbar nach der Entnahme aus dem Pulverbett sintern zu können.

Die Verfestigungszusammensetzung enthält bevorzugt gelöste Bindemittel, insbesondere ausgewählt aus der Gruppe Dextrin, Maltodextrin, Stärkederivate, Cellulose, Polyvinylalkohol, Polyvinylalkohol, Polyvinylpyrrolidon, Polyethylenglykol, Zucker, Zuckerderivate oder beliebige Kombinationen der vorgenannten Substanzen.

Um die Maßhaltigkeit des Bauteils zu gewährleisten ist es wichtig, die Schwindung exakt zu kennen und diese beim CAD-Modell für den Druckvorgang als Aufmaß zu berücksichtigen.

Ein wesentliches Ziel ist, dass die gefertigten Prototypen Werkstoffeigenschaften aufweisen, wie sie in der Serienfertigung zu erwarten sind. Hierzu zählt insbesondere die Dichte. Um eine Verdichtung zu erzielen, ist es möglich den Grünkörper in einem weiteren Schritt zu infiltrieren und auf diesem Wege eine geschlossene Oberfläche zu erzielen.

Die Einhaltung von Toleranzen und die Reproduzierbarkeit der Geometrie sind für die Fertigung von wesentlicher Bedeutung. Mittels 3D-Druck hergestellte keramische Komponenten weisen eine Reproduzierbarkeit von ± 10 µm auf. In dieser Größenordnung liegt auch die verfahrensbedingte Ausbildung von Stufen auf gekrümmten Flächen.

Die Erfindung zielt darauf ab, Dispersionen, die Organoelementverbindungen oder Kolloide enthalten, auf mikroskopischer Ebene gezielt in ein aus einem Pulver generiertes Bauteil so zu platzieren, dass nach dem Sintern ein keramisches Gefüge entsteht, dass in exakt definierten Bereichen unterschiedliche Eigenschaften in Bezug auf chemische Zusammensetzung, Phasenbestand und/oder Korngröße aufweist. Dadurch ist es möglich, einem keramischen Bauteil ein auf den jeweiligen Belastungsfall angepasste Gefüge mit lokalen Eigenschaftsunterschieden zu verleihen.

Es kann auch kein Bindemittel eingesetzt werden. Dann hat dies den Vorteil, dass im resultierenden keramischen Formkörper weniger organische Verunreinigungen vorhanden sind, sofern organische Dispergiermittel eingesetzt werden, und dieser eine geringere Porosität aufweist.

Vorzugsweise wählt man als Dispergiermittel Wasser oder ein organisches Dispergiermittel oder eine Mischung derselben aus. Insbesondere beträgt der Anteil an Wasser am Dispergiermittel mindestens 50 Gew.-%. So kann vermieden werden, dass zu viel organische Rückstände zurückbleiben und während der Sinterung zu Kohlenstoffverunreinigung führen. Als organisches Dispergiermittel setzt man beispielsweise Alkohole, Ketone oder Polyether ein.

Man wählt beim erfindungsgemäßen Verfahren vorteilhafterweise eine Schichtdicke des keramischen Pulvers und gegebenenfalls des Bindemittels in einem Bereich von 10 bis 300 µm, insbesondere von 50 bis 120 µm aus. Würde man eine geringere Schichtdicke auswählen, würde sich das Verfahren über Gebühr verlangsamen. Wählt man die Schichtdicke andererseits zu groß oberhalb der Bereiche, verringert sich die Abbildungsgenauigkeit erheblich. Zudem würde sich die Oberflächenrauhigkeit durch Bildung von Treppeneffekten erhöhen.

Man setzt vorzugsweise ein Pulver aus Oxid, Silicid, Nitrid und/oder Carbid der Elemente Al, B, Bi, Ca, Ce, Cr, Cu, K, Fe, Ga, Ge, In, Li, Mg, Mn, Mo, Na, Si, Sn, Sr, Ta, Ti, W, Y und/oder Zr oder Mischungen derselben ein. Ganz besonders bevorzugt wird als Pulver Aluminiumoxid, Siliciumoxid oder ein Mischoxid, insbesondere Silikate wie beispielsweise Feldspäte, dieser Oxide eingesetzt. Gleichermaßen erfindungsgemäß sind auch Mischoxide der zuvor genannten Oxide, sowie Mischnitride, Mischcarbide, Carbonitride, Oxinitride oder Oxicarbide der zuvor genannten Elemente. Diese keramischen Materialien haben sich als besonders geeignet für das erfindungsgemäße Verfahren erwiesen. Das keramische Pulver hat vorzugsweise eine Korngröße im Bereich von 0,1 bis 500 µm, insbesondere in einem Bereich von 1 bis 100 µm. Dadurch wird zum einen eine zu hohe Oberflächenrauhigkeit im späteren Formkörper vermieden und zum anderen Kontamination durch Absorption an der hohen BET-Oberfläche bei zu kleinen Körnern ebenfalls vermieden.

Das keramische Pulver setzt man vorzugsweise in einer Menge von 85 bis 100 Gew.-% ein. Dadurch ist der Gehalt an Keramikmaterial hinreichend hoch um dennoch genügend Spielraum für beispielsweise die gegebenenfalls vorhandenen Bindemittel zu haben.

Die Bindemittel wiederum sind vorteilhafterweise ausgewählt aus Sacchariden, Gummiarabikum, Harz, Zelluloseleinen, Wachs, Kasein, Epoxidharz, Polyurethan oder Mischungen derselben. Insbesondere ist das Bindemittel ausgewählt aus der Gruppe Stärke, Zucker und/oder Dextrin. Es hat sich herausgestellt, dass diese Bindemittel zum einen eine hohe Kompatibilität mit keramischen Werkstoffen aufweisen und zum anderen am wenigsten unerwünschte keramische Kontaminationen in den entstehenden Formkörpern erzeugen.

Das Bindemittel setzt man vorzugsweise in einer Menge von 1 bis 15 Gew.-% ein. Unterhalb von 1 Gew.-% verliert es seine Wirkung. Oberhalb von 15 Gew.-% kommt es zu sehr zu unerwünschten organischen Kontaminationen im Grünkörper bzw. im Formkörper.

Das Bindemittel hat beispielsweise eine Korngröße im Bereich von 0,1 bis 500 µm, insbesondere in einem Bereich von 5 bis 30 µm.

Sollen mit dem erfindungsgemäßen Verfahren Gegenstände hergestellt werden, die einen Überhang im Vergleich zum benetzten Teil der ersten Schicht haben (beispielsweise eine Kugel), so wählt man vorzugsweise die Schichtdimension der ersten Schicht so, dass sie die maximale Ausdehnung des resultierenden Grünkörpers aufweist.

Die Unterlage im Sinne der Erfindung ist für die erste Schicht nicht zu dem Grünkörper gehörig und für die folgenden Schichten die jeweils vorige Schicht. Die Unterlage, auf der die erste Schicht gebildet wird, ist vorzugsweise ausgewählt aus Kunststoff und/oder Metall. Die Schicht bildet man durch Aufbringen des Pulvers auf die Unterlage bzw. die zuvor gebildete Schicht und anschließendes Nivellieren des aufgebrachten Pulvers, indem beispielsweise mit einem geraden Gegenstand in einem der gewünschten Schichtdicke entsprechenden Abstand von der vorigen Schicht oder der Unterlage über das aufgebrachte Pulver gefahren wird und so überschüssiges Pulver abgetragen wird.

Die Verfestigungszusammensetzung wird mit einem Druckkopf eines Tintenstrahldruckers, einem Mikrodispenser, einem Mikrodosierer, einem Piezodruckkopf oder einem frei programmierbaren Dosiersystem aufgebracht. Dadurch können Standardkomponenten aus anderen Anwendungsbereichen eingesetzt werden und so das Verfahren deutlich vereinfachen.

In der Verfestigungszusammensetzung können beispielsweise auch übliche Zusatzstoffe wie Tenside, Dispergiermittel, pH-Einstellmittel, Emulgatoren, Stellmittel, Entschäumer, Konservierungsmittel, Trocknungsverzögerungsmittel, Additive zur Steuerung der Rheologie, Netzmittel, Antioxidantien, UV-Absorber, Lichtstabilisatoren oder eine Kombination davon enthalten sein. Beispielsweise sind diese Zusatzstoffe in einer Menge in einem Bereich von 0,05 bis 2 Gew.-% enthalten.

Vorteilhafterweise beträgt die Viskosität der Verfestigungszusammensetzung höchstens 105 mPas x s, bevorzugt höchstens 50 mPa x s bei 20 °C und 1 bar. Besonders bevorzugt liegt die Viskosität in einem Bereich von 1 bis 100 mPas x s, bevorzugt 5 bis 50 mPa x s bei 20 °C und 1 bar. Die Viskosität kann mit einem Brookfield CAP 1000+ Viskosimeter mit der Spindel CAP-S-01 mit einer Umdrehungsgeschwindigkeit von 750 U/min gemessen werden.

Vorteilhafterweise liegt die Oberflächenspannung der Verfestigungszusammensetzung in einem Bereich von 20 bis 70 mN/m, bevorzugt 30 bis 40 mN/m bei 20 °C und 1 bar. Die Oberflächenspannung kann gemäß der DIN 55660-3:2011-12 bestimmt werden.

In Schritt c) werden die Schritte a) und b) vorzugsweise wenigstens 50mal, insbesondere wenigstens 100mal wiederholt, damit die bei diesen Verfahren inhärent immer vorhandenen Treppeneffekte auf der Oberfläche möglichst minimiert werden.

Die Entfernung des Dispergiermittels, insbesondere des Wassers, geschieht beispielsweise durch Trocknen. Dabei kann die Zeitdauer der Entfernung des Dispergiermittels beispielsweise in einem Bereich von 8 bis 48 h liegen. Die Temperatur dabei liegt beispielsweise in einem Bereich von 15 bis 150 °C, insbesondere in einem Bereich von 30 bis 80 °C. Die Atmosphäre, in der die Entfernung des Dispergiermittels stattfindet ist beispielsweise Luft. Während der Entfernung des Dispergiermittels kann eine Strömung der Atmosphäre durch einen Lüfter, durch Anlegen eines Vakuums oder durch Konvektion herbeigeführt werden. Je nach eingesetztem keramischen Pulver bildet sich eine Hydrathülle oder andere Verbindungen mit dem Dispergiermittel, so dass das Dispergiermittel nur schwer vollständig entfernt werden kann. Im Sinne der Erfindung ist daher vorzugsweise die Entfernung des Dispergiermittels als vollständig zu betrachten, wenn gegen Ende der Trocknung kein weiterer Abgang von Dispergiermittel beobachtet werden kann, also das Gewicht im Wesentlichen konstant bleibt.

Das Entfernen des nicht gebundenen keramischen Pulvers erfolgt beispielsweise durch Ausschütteln oder Ausblasen.

Beim Applizieren der Verfestigungszusammensetzung wählt man beispielsweise eine Düsenöffnung in einem Bereich von 10 bis 100 µm und unabhängig davon eine Tropfengröße in einem Bereich von 5 bis 100 µm. Durch die erfindungsgemäße Tropfengröße kann die Oberfläche des keramischen Pulvers besonders gleichmäßig benetzt werden.

Die weitere Verfestigungszusammensetzung wird beispielsweise unmittelbar vor dem Auftragen mit der ersten Verfestigungszusammensetzung vermischt. Beispielsweise kann dies in einem Druckkopf eines Tintenstrahldruckers geschehen.

Das erfindungsgemäße Verfahren eignet sich also dazu, ein 3D-Gefügedesign eines keramischen Formkörpers zu erstellen, das sehr flexibel gestaltet werden kann. So können die keramischen Formkörper mit den unterschiedlichsten Eigenschaften ortsaufgelöst versehen werden. Dies wird dadurch möglich, dass beliebige Konzentrationen von den unterschiedlichsten Materialien sehr genau im keramischen Formkörper positioniert werden können. Unterschiedlichste Elementverteilungen lassen sich so gezielt platzieren. Diese unterschiedlichen Elementverbindungen können im erfindungsgemäßen Verfahren im selben Arbeitsschritt beispielsweise aus verschiedenen Tanks mit demselben Druckkopf oder aus verschiedenen Druckköpfen auf die Schicht mit dem keramischen Pulver aufgetragen werden.

Das erfindungsgemäße Verfahren eignet sich darüber hinaus nicht nur zur Erstellung von Prototypen, sondern kann auch in der Serienfertigung Einsatz finden.

Beispielsweise kann zunächst in einem Computer ein 3D-Modell des Grünkörpers erstellt werden. Dieser kann dann im Computer in Scheiben zerlegt werden, die von der Dicke her der angestrebten Schichtdicke des keramischen Pulvers entsprechen. Dabei kann beispielsweise mit Farbgradienten gesteuert werden, welcher der gegebenenfalls verschiedenen Tanks mit Verfestigungszusammensetzung diese Zusammensetzung an den Druckkopf abgibt. Beispielsweise kann in dem Tank, der in einem gewöhnlichen Tintenstrahldrucker blaue Tinte enthält, eine Verfestigungszusammensetzung enthaltend eine Titantetrachlorid - Lösung eingeführt werden. In einen weiteren Tank kann eine Lösung von Kupfercitrat als Verfestigungszusammensetzung eingefüllt werden, der üblicherweise gelbe Tinte enthält. Mit Hilfe eine Computers kann man nun beispielsweise im 3D-Modell einen Gradienten von blau nach gelb über den Formkörper hinweg definieren. Werden diese Daten nun an den Drucker übertragen, so ergibt sich ein Grünkörper, der zu einem Formkörper führt, der auf der einen Seite des Gradienten beispielsweise photokatalytisch aktiv ist, auf der anderen Seite des Gradienten besonders wärmeleitend ist, und dazwischen einen fließenden Übergang dieser Eigenschaften aufweist.

Dazu wird beispielsweise ein mittels Sprühgranulation aufbereitetes Pulver mit einem organischen Binder, beispielsweise Kartoffelstärke, gemischt und in einen Z-Printer 510 (Z-Corporation, USA) gegeben. Unter Verwendung der wasserbasierten Binderlösung (ZB54, Z-Corporation), die über einen Tintenstrahldruckknopf aufgetragene wird, kann das zu fertigende Bauteil schichtweise, entsprechend der CAD-Daten, aufgebaut werden. Nach dem Druckvorgang erfolgt beispielsweise ein Trocknen und Freiblasen der Teile sowie der abschließende Sinterbrand.

Der Z-Printer 310 wird üblicherweise angeboten, um farbige Gipsmodelle herzustellen. Dazu ist er, entsprechend einem Tintenstrahldrucker, mit 4 Farben ausgerüstet. Anstelle von gefärbtem Binder ist es beispielsweise denkbar, Dispersionen mit unterschiedlichen metallorganischen Verbindungen zu nutzen. Hierdurch kann das Basis-Al₂O₃-Pulver beispielsweise in variabler Menge mit den verschiedenen Zusammensetzungen besprüht werden. Im Drucker stehen üblicherweise drei Farbkammern zu Verfügung. Durch Befüllen mit Lösungen von organometallischen Verbindungen oder Kolloiddispersionen können die gewünschten Komposit- oder Mischoxidkeramiken im µm-Maßstab bis hin zum mm-Maßstab gedruckt werden. Gemäß einer ästhetischen Vorgabe kann in dunkel gefärbten Bereichen z.B. Eisencitrat aufgesprüht werden. In diesem Bereich bildet sich während des Sinterns ein Werkstoff mit deutlich höheren Eisenoxidbestandteilen aus. Beispielsweise können auch gezielt elektrische Leiterbahnen in keramische Formkörper dreidimensional gelegt werden, indem Chloroplatin(IV)-säure der Verfestigungslösung zugesetzt wird. Damit lassen sich beispielsweise individuell angepasste Heizelemente herstellen, wenn das übrige keramische Material als Isolator ausgewählt wird.

Beschrieben wird auch ein Grünkörper, der nach dem erfindungsgemäßen Verfahren hergestellt ist.

Beschrieben wird auch ein Verfahren zur Herstellung eines keramischen Formkörpers, wobei zunächst das erfindungsgemäße Verfahren durchgeführt wird und anschließend der Grünkörper gesintert wird.

Dabei wählt man die Sintertemperatur beispielsweise in einem Bereich zwischen 1000 und 2000 °C und davon unabhängig die Haltezeit in einem Bereich von 0,5 bis 10 h, insbesondere 1 bis 4 h.

Beschrieben wird auch ein Formkörper, der nach dem erfindungsgemäßen Verfahren hergestellt wurde.

Der Formkörper weist beispielsweise eine Porosität im Bereich von 0 bis 60 %, besonders bevorzugt im Bereich von 0 bis 20 % auf. Davon unabhängig weist der keramische Formkörper beispielsweise ein E-Modul in einem Bereich von 100 bis 400 GPa auf. Davon wiederum unabhängig weist der keramische Formkörper beispielsweise eine Festigkeit in einem Bereich von 150 bis 400 MPa.

Vorzugsweise ist der Formkörper ausgewählt aus Zahnersatz, Strukturkeramik, Funktionskeramik und/oder ein gesinterten Keramikträger für komplexe Schaltungen
Beim Zahnersatz hat die erfindungsgemäße Technologie beispielsweise den Vorteil, dass ein kontinuierlicher Farbverlauf, individuelle Farbgebung und natürliches Aussehen nach dem Vorbild echter Zähne erzielt werden kann.

Bei Strukturkeramik kann eine lokale Gefügemodifikation oder Gefügeverstärkung erzielt werden, beispielsweise eine Steigerung der Festigkeit (beispielsweise durch ZrO₂ in Al₂O₃), eine Steigerung der Temperaturwechselbeständigkeit (beispielsweise Mullit in Korund), beispielsweise eine Erhöhung der Wärmeleitfähigkeit (beispielsweise AIN in Al₂O₃), beispielsweise eine lokale Variation der Dichte oder Porosität, oder beispielsweise eine Variation der Porengröße zur selektiven Filtration von Gasen oder Flüssigkeiten.

Bei Funktionskeramik kann eine Integration elektrisch, magnetisch oder induktiv leitender Strukturen in isolierende Komponenten oder auch die Integration von Aktoren oder Sensoren in Multi-Funktionsbauteilen erzielt werden.

Auf der Basis von gesinterten Keramikträgern können komplexe Schaltungen hergestellt werden. Im Gegensatz zur gängigen LTCC-Technik, bei der Mehrlagenschaltungen durch bedrucken (Siebdruck) von keramischen Folien erzeugt werden, können mittels dem erfindungsgemäßen Verfahren Leiterbahnen, Kondensatoren, Widerstände und Spulen in 3-dimensional beliebiger Anordnung erzeugt werden.

### Ausführungsbeispiel

Es wurde ein Aluminiumoxid-Pulver (CT3000SG, Almatis, Ludwigshafen, Deutschland) mittels Wirbelschicht-Granulation (GPCG, Glatt, Dresden, Deutschland) aufbereitet. Die Granulate wurden <150 µm abgesiebt und anschließend mit 7 Masse-% Kartoffeldextrin-Pulver, Korngröße 115 µm (Superior gelb F, Südstärke, Schrobenhausen, Deutschland), vermischt.

Der wasserbasierten Binderlösung (ZB54, Z-Corporation, USA) wurden 10 Ms-% von Eisencitrat (F6129-250G, Sigma-Aldrich Chemie, Taufkirchen, Deutschland) zugesetzt. Die Komponenten wurden in einem Becherglas mittels Magnetrührer 5 Minuten gemischt.

Mit einem CAD-Programm wurden stäbchenförmige Körper (1 cm X 1 cm X 5 cm) zum Zweck der Probenherstellung entworfen. Diese wurden von einem Ende des Riegels zum anderen farbig (gelb nach blau) gradiert. Der Datensatz wurde vom 3D-Drucker (Z-510, Z-Corporation, USA) umgesetzt. Die Schichtdicke wurde auf 0,088 mm und die Sättigung maximal eingestellt.

In einen Bindertank wurde eine reine Binderlösung (ZB 54) gefüllt, in die zweite die Mischung der Binderlösung mit Eisencitrat. Entsprechend der farbigen Gradierung wurden die beiden Binder in unterschiedlichem Verhältnis während des Druckprozesses auf das Pulverbett gebracht.

Die gedruckten Proben wurden bei Raumtemperatur im Pulverbett des 3D-Druckers 12 h getrocknet. Danach wurden die Probekörper entnommen und in einem Trockenschrank bei 60 °C weitere 12 h vollständig getrocknet. Anschließend wurden die Probekörper von ungebundenem Pulver mittels Pinsel und Druckluft befreit.

Die Sinterung der Probekörper erfolgte bei 1600 °C, 2 h Haltezeit.

## Patentansprüche

1. Verfahren zur Herstellung eines Grünkörpers, bei dem man
a) eine Schicht, die ein keramisches, glaskeramisches oder Glaspulver enthält, auf einer Unterlage bildet,
wobei die Schicht durch Aufbringen des Pulvers auf die Unterlage bzw. die zuvor gebildete Schicht und anschließendes Nivellieren des aufgebrachten Pulvers gebildet wird,
b) mindestens eine flüssige Verfestigungszusammensetzung auf die zuvor genannte Schicht auf zumindest einen Teil davon appliziert, die wenigstens 0,01 bis 99,98 Gew.% wenigstens einer gelösten oder flüssigen organometallischen Verbindung enthält, wobei diese wenigstens ein Atom aufweist, das nicht C, Si, H, O oder N ist, und dieses Atom an wenigstens einen organischen Rest gebunden ist,
0,01 bis 20 Gew.% eines organischen Binders,
0,01 bis 99,98 Gew.% Lösungsmittel oder Dispergiermittel enthält, wobei die Verfestigungszusammensetzung mit einem Druckkopf eines Tintenstrahldruckers, einem Mikrodispenser, einem Mikrodosierer, einem Piezodruckkopf oder einem frei programmierbaren Dosiersystem aufgebracht wird, und
wobei die Verfestigungszusammensetzung keine Feststoffe enthält,
c) Schritte a) und b) mindestens einmal wiederholt,
d) das Lösungsmittel oder Dispergiermittel unter Bildung eines Grünkörpers wenigstens teilweise oder vollständig entfernt, und
e) nicht gebundenes keramisches Pulver entfernt, wobei der Grünkörper freigelegt wird.

2. Verfahren gemäß Anspruch 1, **dadurch gekennzeichnet, dass** die Schicht in a) auch Bindemittel enthält.

3. Verfahren gemäß einem der Ansprüche 1 bis 2, **dadurch gekennzeichnet, dass** man als Dispergiermittel Wasser oder organisches Dispergiermittel auswählt.

4. Verfahren gemäß einem der Ansprüche 1 bis 3, **dadurch gekennzeichnet, dass** man eine Schichtdicke des keramischen Pulvers und des Bindemittels in einem Bereich von 10 bis 300 µm, insbesondere in einem Bereich von 50 bis 120 µm auswählt.

5. Verfahren gemäß einem der Ansprüche 1 bis 4, **dadurch gekennzeichnet, dass** man ein Pulver aus Oxid, Silicid, Nitrid und/oder Carbid der Elemente Al, B, Bi, Ca, Ce, Cr, Cu, K, Fe, Ga, Ge, In, Li, Mg, Mn, Mo, Na, Si, Sn, Sr, Ta, Ti, W, Y und/oder Zr oder Mischungen derselben einsetzt.

6. Verfahren gemäß einem der Ansprüche 1 bis 5, **dadurch gekennzeichnet, dass** anschließend der Grünkörper gesintert wird.

## Claims

1. A process for producing a green body, wherein
a) a layer containing a ceramic, glass-ceramic or glass powder is formed on a substrate,
wherein the layer is formed by applying the powder on the substrate or the previously formed layer and subsequently levelling the applied powder,
b) at least a part of the above-mentioned layer is coated with at least one liquid solidifying composition which contains at least from 0.01 to 99.98% by weight of a dissolved or liquid organometallic compound, wherein the same has at least one atom which is not C, Si, H, O or N, and this atom is bonded to at least one organic moiety,
from 0.01 to 20% by weight of an organic binding agent,
from 0.01 to 99.98% by weight of a solvent or dispersing agent,
wherein the solidifying composition is applied with the print head of an inkjet printer, a microdispenser, a micro-feeder, a piezo print head or a freely programmable dosing system, and
wherein the solidifying composition does not contain solids,
c) steps a) and b) are repeated at least once,
d) the solvent or dispersing agent is removed at least partially or completely to form a green body, and
e) unbonded ceramic powder is removed, whereby the green body is exposed.

2. The process according to claim 1, **characterised in that** the layer a) also contains binding agents.

3. The process according to any one of claims 1 to 2, **characterised in that** water or an organic dispersing agent is selected as the dispersing agent.

4. The process according to any one of claims 1 to 3, **characterised in that** the layer thickness of the ceramic powder and the binding agent is selected from a range from 10 to 300 µm, especially from a range from 50 to 120 µm.

5. The process according to any one of claims 1 to 4, **characterised in that** a powder of an oxide, silicide, nitride and/or carbide of the elements Al, B, Bi, Ca, Ce, Cr, Cu, K, Fe, Ga, Ge, In, Li, Mg, Mn, Mo, Na, Si, Sn, Sr, Ta, Ti, W, Y and/or Zr or mixtures thereof is used.

6. The process according to any one of claims 1 to 5, **characterised in that** the green body is subsequently sintered.

## Revendications

1. Procédé de production d'un compact vert, dans lequel
a) une couche contenant une poudre céramique, vitrocéramique ou de verre est formée sur un support,
dans lequel la couche est formée grâce à l'application de la poudre sur le support ou la couche précédemment formée et au nivellement ultérieur de la poudre appliquée,
b) au moins une composition liquide de renforcement contenant entre au moins 0,01 et 99,98 % en poids d'au moins un composé organométallique en solution ou liquide est appliquée sur au moins une partie de la couche précitée, dans lequel ledit composé présente au moins un atome qui n'est pas C, Si, H, O ou N, et ledit atome est lié à au moins un radical organique,
entre 0,01 et 20 % en poids d'un liant organique, entre 0,01 et 99,98 % en poids de solvant ou de dispersant,
dans lequel la composition de renforcement est appliquée avec une tête d'impression d'une imprimante à jet d'encre, une micropipette, un microdoseur, une tête d'impression piézo ou un système de dosage librement programmable, et
dans lequel la composition de renforcement ne contient pas de substances solides,
c) les étapes a) et b)sont répétées au moins une fois,
d) le solvant ou le dispersant est éliminé au moins partiellement ou complètement pour former un compact vert, et
e) la poudre céramique non liée est éliminée, dans lequel le compact vert est laissé nu.

2. Procédé selon la revendication 1, **caractérisé en ce que** la couche de l'étape a) contient également des liants.

3. Procédé selon l'une quelconque des revendications 1 à 2, **caractérisé en ce que** de l'eau ou un dispersant organique est choisi en tant que dispersant.

4. Procédé selon l'une quelconque des revendications 1 à 3, **caractérisé en ce qu'**une épaisseur de couche de la poudre céramique et du liant située dans une plage comprise entre 10 et 300 µm, en particulier dans une plage comprise entre 50 et 120 µm, est choisie.

5. Procédé selon l'une quelconque des revendications 1 à 4, **caractérisé en ce qu'**une poudre constituée d'oxyde, de siliciure, de nitrure et/ou de carbure des éléments Al, B, Bi, Ca, Ce, Cr, Cu, K, Fe, Ga, Ge, In, Li, Mg, Mn, Mo, Na, Si, Sn, Sr, Ta, Ti, W, Y et/ou Zr ou des mélanges de ceux-ci est utilisée.

6. Procédé selon l'une quelconque des revendications 1 à 5, **caractérisé en ce que** le compact vert est ensuite fritté.
